# EUROPEAN PATENT SPECIFICATION

(11) **EP 4 145 155 B1**
(45) Date of publication and mention of the grant of the patent: **25.03.2026**
(21) Application number: 21898698.2
(22) Date of filing: 26.11.2021
(51) Int. Cl.: G01R 31/367, G01R 31/36, G06N 20/00, H01M 10/48, H01M 10/42, G01R 31/392, H01M 10/44, H01M 10/052

(54) **BATTERY MANAGEMENT APPARATUS AND METHOD**
BATTERIEMANAGEMENTVORRICHTUNG UND -VERFAHREN
APPAREIL ET PROCÉDÉ DE GESTION DES BATTERIES

(30) Priority: 26.11.2020 KR 20200161667
(43) Date of publication of application: 08.03.2023
(73) Proprietor: LG Chem, Ltd., Seoul 07336 (KR)
(72) Inventor: JO, Pil-Sung, Daejeon 34122 (KR); LEE, Seok-Kyeong, Daejeon 34122 (KR); PARK, Sung-Bin, Daejeon 34122 (KR); PARK, Soo-Min, Daejeon 34122 (KR); LEE, Chang-Song, Daejeon 34122 (KR)
(74) Representative: Goddar, Heinz J.
(86) International application number: PCT/KR2021/017686
(87) International publication number: WO 2022/114873

(56) References cited:
- JP-A- 2020 145 186
- JP-A- H09 215 208
- KR-A- 20090 020 362
- KR-A- 20130 113 296
- KR-A- 20160 090 140
- US-A1- 2013 268 466
- US-A1- 2019 392 320
- US-A1- 2020 184 370
- US-A1- 2020 303 938

## Description

### TECHNICAL FIELD

The present disclosure relates to a battery management apparatus and method, and more particularly, to a battery management apparatus and method capable of judging the state of a battery using a learned classification model.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium-ion batteries and the like. Among them, the lithium-ion batteries are in the limelight since they have almost no memory effect compared to nickel-based batteries and also have very low self-charging rate and high energy density.

Conventionally, in order to estimate or judge the state of the battery, machine learning-based or deep learning-based techniques are grafted. For example, a technology for judging the state of a battery based on a learned model is being developed.

To learn such a model, a large amount of training data is required. In order to secure the training data from the battery, the charging and discharging cycle of the battery must proceed, so it may take a lot of time to secure a large amount of training data. In addition, as the life expectancy of the battery increases, the time required for the charging and discharging cycle also increases proportionally, so the time required to secure the learning data is increasing.

Also, there is a limit to the number of learning data that can be secured from a limited number of batteries. Therefore, even if the number of batteries is limited, it is necessary to develop a technology capable of improving the performance of the learned model by securing a large amount of learning data.

US 2019/392320 A1 discloses a controlling method of a battery which includes learning an artificial neural network to obtain first characteristic data inside the battery corresponding to first input and output data; collecting second input and output data for a period of time by charging or discharging the battery based on the obtained first characteristic data and user's usage environment information; updating a parameter of the artificial neural network based on the collected second input and output data; and learning the artificial neural network to obtain second characteristic data inside the battery corresponding to the collected second input and output data based on the updated parameter.

US 2020/303938 A1 discloses an electronic device that includes a battery and a battery management system. The battery management system is configured to derive a predicted battery demand based on observed usage patterns to predictively charge the battery to healthily accommodate the predicted battery demand. The battery management system is further configured to determine a predicted deviating battery demand based on a contextual signal. The predicted deviating battery demand differing from the predicted battery demand. The battery management system is further configured to predictively charge the battery to healthily accommodate the predicted deviating battery demand.

### SUMMARY

The present disclosure is designed to solve the problems of the related art, and therefore the present disclosure is directed to providing a battery management apparatus and method capable of securing a large amount of learning data for learning a classification model from a limited number of batteries.

The invention is defined by the subject matter of the independent claims. Advantageous embodiments are subject to the dependent claims.

These and other objects and advantages of the present disclosure may be understood from the following detailed description and will become more fully apparent from the exemplary embodiments of the present disclosure. Also, it will be easily understood that the objects and advantages of the present disclosure are realized by the means shown in the appended claims.

According to one aspect of the present disclosure, there is an advantage in that it is possible to quickly obtain a large amount of learning data for learning a classification model from a limited number of batteries.

### BRIEF DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an aspect of the present disclosure.
FIG. 2 is a diagram schematically showing the first embodiment in which a label is set by the battery management apparatus according to an aspect of the present disclosure.
FIG. 3 is a diagram schematically showing the second embodiment in which a label is set by the battery management apparatus according to an aspect of the present disclosure.
FIG. 4 is a diagram schematically showing the third embodiment in which a label is set by the battery management apparatus according to an aspect of the present disclosure.
FIG. 5 is a diagram schematically showing an exemplary configuration of a battery pack according to another aspect of the present disclosure.
FIG. 6 is a diagram schematically showing a battery management method according to still another aspect of the present disclosure.

### DETAILED DESCRIPTION

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

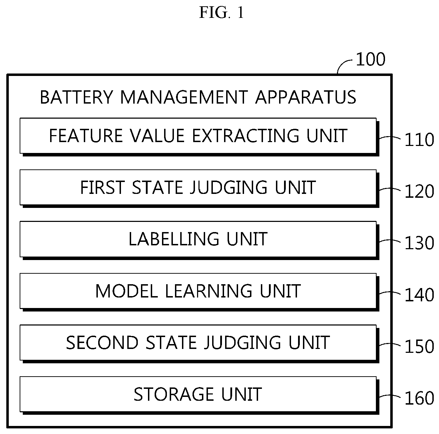

FIG. 1 is a diagram schematically showing a battery management apparatus 100 according to an aspect of the present disclosure.

Referring to FIG. 1, the battery management apparatus 100 includes a feature value extracting unit 110, a first state judging unit 120, a labeling unit 130, a model learning unit 140, and a second state judging unit 150.

The feature value extracting unit 110 is configured to extract a feature value of a learning battery at every charging and discharging cycle.

Here, the battery means one physically separable independent cell including a negative electrode terminal and a positive electrode terminal. For example, one pouch-type lithium-ion battery cell may be regarded as a battery.

In addition, the learning battery is a battery for obtaining a learning data set for learning a classification model, and is distinguished from an analysis battery.

For example, the feature value extracting unit 110 extracts at least one feature value for the learning battery at every charging and discharging cycle. Specifically, the feature value extracting unit 110 may extract a feature value according to voltage, current, capacity, charging time, internal resistance, SOC (State of Charge), SOH (State of Health) or a combination thereof for the learning battery.

The first state judging unit 120 is configured to judge the state of the learning battery at every charging and discharging cycle, based on the feature value extracted by the feature value extracting unit 110 and a preset criterion value that corresponds to the feature value. The criterion value is preset for each feature value for each charging and discharging cycle.

For example, it is assumed that first to N^{th} feature values for the learning battery are extracted at each of the first to N^{th} charging and discharging cycles. Here, N may be an integer of 2 or more. In this case, a total of N criterion values may be preset. That is, the first to N^{th} criterion values may be preset to correspond to the first to N^{th} feature values, respectively. In addition, the first state judging unit 120 may judge the state of the learning battery at the first charging and discharging cycle by comparing the first feature value and the first criterion value. Similarly, the first state judging unit 120 may judge the state of the learning battery at the N^{th} charging and discharging cycle by comparing the N^{th} feature value and the N^{th} criterion value.

Specifically, the first state judging unit 120 is configured to judge the state of the learning battery as a normal state or a defective state at every charging and discharging cycle.

For example, the criterion value is a threshold value for judging the state of the learning battery. The first state judging unit 120 may judge the state of the learning battery as a normal state or a defective state by comparing the magnitudes of the criterion value and the feature value.

The labeling unit 130 is configured to set a label for the feature value of the learning battery at every charging and discharging cycle, based on the state of the learning battery judged by the first state judging unit 120.

Specifically, the labeling unit 130 may be configured to set a first label for the feature value of the learning battery at the corresponding charging and discharging cycle, when the state of the learning battery is judged as a normal state.

Conversely, the labeling unit 130 may be configured to set a second label for the feature value of the learning battery at the corresponding charging and discharging cycle, when the state of the learning battery is judged as a defective state.

That is, the labeling unit 130 sets a label for the feature value of the learning battery extracted at each charging and discharging cycle according to the state of the learning battery judged by the first state judging unit 120.

The model learning unit 140 is configured to learn a classification model for judging the state of the analysis battery based on the feature value for which the label is set by the labeling unit 130.

For example, logistic regression, linear discriminant analysis, support vector machine, random forest classifier, or artificial neural network may be applied as the classification model.

The classification model learned by the model learning unit 140 is used to judge the state of the analysis battery.

However, since the process of learning the classification model based on the feature value for which the label is set is a general model learning in the machine learning, a detailed description thereof will be omitted.

The second state judging unit 150 is configured to judge the state of the analysis battery based on the classification model learned by the model learning unit 140.

Specifically, the second state judging unit 150 may be configured to extract a feature value of the analysis battery at every charging and discharging cycle.

Here, the feature value of the analysis battery may be in the same kind as the feature value of the learning battery extracted by the feature value extracting unit 110. That is, the feature value of the analysis battery extracted by the second state judging unit 150 may be in the same kind as the feature value used in the process of learning the classification model by the model learning unit 140.

For example, it is assumed that the feature value extracting unit 110 extracts the voltage for the learning battery as a feature value at every charging and discharging cycle. The first state judging unit 120 may judge the state of the learning battery at every charging and discharging cycle based on the voltage of the learning battery and a criterion value. The labeling unit 130 may set a label for the voltage of each charging and discharging cycle, based on the state of the learning battery judged at every charging and discharging cycle. The model learning unit 140 may learn the classification model based on the voltage for which the label is set. The second state judging unit 150 may extract the voltage for the analysis battery as a feature value at every charging and discharging cycle.

In addition, the second state judging unit 150 may be configured to judge the state of the analysis battery by inputting the extracted feature value to the learned classification model.

For example, the second state judging unit 150 may set the feature value of the analysis battery as an input to the learned classification model. In addition, the learned classification model may output the state for the analysis battery as an output for the input. The second state judging unit 150 may obtain the output that is output from the learned classification model and judge the state of the analysis battery as a normal state or a defective state.

The battery management apparatus 100 according to an embodiment of the present disclosure has an advantage of securing a large amount of learning data for learning the classification model from a limited number of batteries.

That is, since the battery is degraded as the charging and discharging cycle progresses, the state of the battery at each charging and discharging cycle may be different. The battery management apparatus 100 may secure a large amount of learning data for learning the classification model by extracting the feature value of the battery at every charging and discharging cycle in consideration of these features of the battery.

Therefore, even if the number of learning batteries is limited, a large amount of learning data for learning the classification model may be secured, and the performance of the learned classification model may be improved based on the large amount of learning data. Therefore, the accuracy of judging the state of the analysis battery based on the learned classification model may be improved.

Meanwhile, referring to FIG. 1, the battery management apparatus 100 may further include a storage unit 160. The storage unit 160 may store data necessary for operation and function of each component of the battery management apparatus 100, data generated in the process of performing the operation or function, or the like. The storage unit 160 is not particularly limited in its kind as long as it is a known information storage means that can record, erase, update and read data. As an example, the information storage means may include RAM, flash memory, ROM, EEPROM, registers, and the like. In addition, the storage unit 160 may store program codes in which processes executable by the control unit are defined.

For example, the feature value of the battery extracted at every charging and discharging cycle by the feature value extracting unit 110 may be stored in the storage unit 160. In addition, the label set for each feature value by the labeling unit 130 may also be stored in the storage unit 160.

In addition, the feature value extracting unit 110 may be configured to extract a plurality of feature values for the learning battery.

Specifically, the feature value extracting unit 110 may extract two or more feature values for each learning battery at every charging and discharging cycle.

For example, the feature value extracting unit 110 may extract voltage and internal resistance for each learning battery at every charging and discharging cycle. If the charging and discharging cycle is performed up to 500 cycles for 10 learning batteries, the total number of feature values extracted by the feature value extracting unit 110 may be 10,000. That is, 5,000 voltages and 5,000 internal resistances may be extracted.

The first state judging unit 120 may be configured to judge the state of the learning battery for each of the plurality of feature values at every charging and discharging cycle, based on the plurality of feature values of the learning battery and a criterion value preset to correspond to each of the plurality of feature values.

For example, in the preceding embodiment, when a total of 10,000 feature values are extracted by the feature value extracting unit 110, the first state judging unit 120 may judge the state of the learning battery for voltage and internal resistance at every charging and discharging cycle by comparing each of the 10,000 feature values with the criterion value corresponding thereto. That is, according to the voltages of 10 learning batteries, the voltage-based state of the learning battery at each of 1^{st} cycle to 500^{th} cycles may be judged. In addition, according to the internal resistance of the 10 learning batteries, the internal resistance-based state of the learning battery at each of 1^{st} cycle to 500^{th} cycles may be judged.

The labeling unit 130 may be configured to set the label for each of the plurality of feature values at every charging and discharging cycle.

For example, in the preceding embodiment, when all the states of the learning battery for 10,000 feature values are judged by the first state judging unit 120, the labeling unit 130 may set a label for each of the 10,000 feature values.

That is, the battery management apparatus 100 according to an embodiment of the present disclosure has an advantage of securing a large amount of learning data from a limited number of learning batteries by extracting a plurality of feature values for the learning battery.

Hereinafter, various embodiments in which the labeling unit 130 sets the label for the feature value will be described.

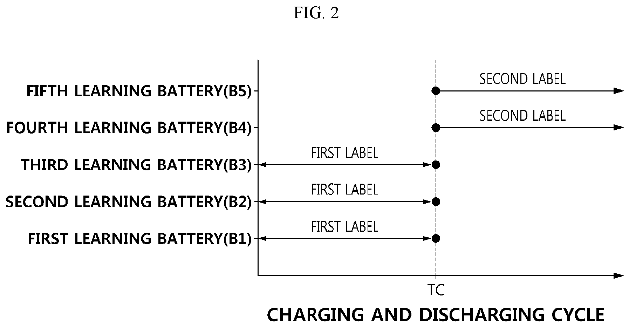

FIG. 2 is a diagram schematically showing the first embodiment in which a label is set by the battery management apparatus 100 according to an aspect of the present disclosure.

The labeling unit 130 may be configured to set a label for the feature value of the learning battery, based on the state of the learning battery judged at a predetermined charging and discharging cycle.

For example, in the embodiment of FIG. 2, the labeling unit 130 may set the label for the feature value of each of the first to fifth learning batteries B1, B2, B3, B4, B5, based on the state of each of the first to fifth learning batteries B1, B2, B3, B4, B5 judged at a target cycle TC.

Here, the target cycle TC may be the last charging and discharging cycle at which the state of the battery is judged by the first state judging unit 120. For example, the target cycle TC may be a cycle related to quality assurance for the battery. As a specific example, if the quality assurance of the battery is set such that 90% or more of the capacity of the battery is preserved at 500^{th} cycle, the target cycle TC may be set to the 500^{th} cycle. In other words, the target cycle TC may be separately set according to the type of the battery, the usage of the battery, the environment in which the battery is used, or the like.

Specifically, when the state of the learning battery at the predetermined charging and discharging cycle is judged as the normal state, the labeling unit 130 may set the first label for the feature value of the learning battery for a charging and discharging cycle up to a cycle just before the predetermined charging and discharging cycle.

Conversely, if the state of the learning battery at the predetermined charging and discharging cycle is judged as the defective state, the labeling unit 130 may set the second label for the feature value of the learning battery at a charging and discharging cycle after the predetermined charging and discharging cycle.

In the embodiment of FIG. 2, it is assumed that the states of the first to third learning batteries B1, B2, B3 are judged as the normal state at the target cycle TC, and the states of the fourth and fifth learning batteries B4, B5 are judged as the defective state. In this case, the states of the first to third learning batteries B1, B2, B3 before the target cycle TC will be the normal state, and the states of the fourth and fifth learning batteries B4, B5 after the target cycle TC will be the defective state.

The labeling unit 130 may set the first label for the feature values of the first to third learning batteries B1, B2, B3 before the target cycle TC.

In addition, the labeling unit 130 may set the second label for the feature values of the fourth and fifth learning batteries B4, B5 after the target cycle TC. That is, the labeling unit 130 may quickly set the label for the feature value even if the states of the fourth and fifth learning batteries B4, B5 are not judged at the charging and discharging cycle after the target cycle TC.

That is, the battery management apparatus 100 may not only set a label for the feature value of the learning battery just before the target cycle TC, but also set a label for the feature value of the learning battery at the charging and discharging cycle after the target cycle TC.

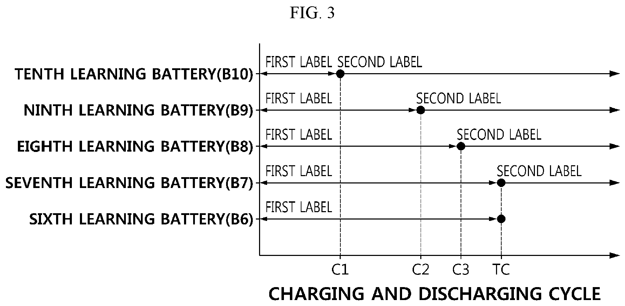

FIG. 3 is a diagram schematically showing the second embodiment in which a label is set by the battery management apparatus 100 according to an aspect of the present disclosure.

The labeling unit 130 may be configured to set the second label for the feature value of the learning battery for a subsequent charging and discharging cycle, when the state of the learning battery is judged as the defective state.

Specifically, the labeling unit 130 may set the second label for the feature value of the learning battery, after the charging and discharging cycle judged as the defective state. That is, after the charging and discharging cycle judged as the defective state, even if the state of the learning battery is not judged by the first state judging unit 120, the labeling unit 130 may set a label for the feature value.

For example, in the embodiment of FIG. 3, the state of the sixth learning battery B6 at the target cycle TC may be judged as a normal state, and the state of the seventh learning battery B7 may be judged as a defective state. The state of the eighth learning battery B8 at the third charging and discharging cycle C3 may be judged as a defective state, and the state of the ninth learning battery B9 at the second charging and discharging cycle C2 may be judged as a defective state. The state of the tenth learning battery B10 at the first charging and discharging cycle C1 may be judged to be a defective state.

The labeling unit 130 may set the first label for the feature value up to a cycle just before the target cycle TC for the sixth learning battery B6.

In addition, the labeling unit 130 may set the first label for the feature value up to a cycle just before the target cycle TC, and set the second label for the feature value after the target cycle TC, for the seventh learning battery B7. That is, even if the state of the seventh learning battery B7 is not judged by the first state judging unit 120 after the target cycle TC, the labeling unit 130 may set the second label for the feature value of the seventh learning battery B7.

In addition, the labeling unit 130 may set the first label for the feature value up to a cycle just before the third charging and discharging cycle C3, and set the second label for the feature value after the third charging and discharging cycle C3, for the eighth learning battery B8. That is, even if the state of the eighth learning battery B8 is not judged by the first state judging unit 120 after the third charging and discharging cycle C3, the labeling unit 130 may set the second label for the feature value of the eighth learning battery B8.

In addition, the labeling unit 130 may set the first label for the feature value up to a cycle just before the second charging and discharging cycle C2, and set the second label for the feature value after the second charging and discharging cycle C2, for the ninth learning battery B9. That is, even if the state of the ninth learning battery B9 is not judged by the first state judging unit 120 after the second charging and discharging cycle C2, the labeling unit 130 may set the second label for the feature value of the ninth learning battery B9.

In addition, the labeling unit 130 may set the first label for the feature value up to a cycle just before the first charging and discharging cycle C1, and set the second label for the feature value after the first charging and discharging cycle C1, for the tenth learning battery B10. That is, even if the state of the tenth learning battery B10 is not judged by the first state judging unit 120 after the first charging and discharging cycle C1, the labeling unit 130 may set the second label for the feature value of the tenth learning battery B 10.

The battery management apparatus 100 according to an embodiment of the present disclosure may set the second label for the feature value without judging the state for the learning battery after the charging and discharging cycle judged as a defective state. Accordingly, the learning data for learning the classification model may be secured more quickly, and system resources of the battery management apparatus 100 may be saved in the process of securing such learning data.

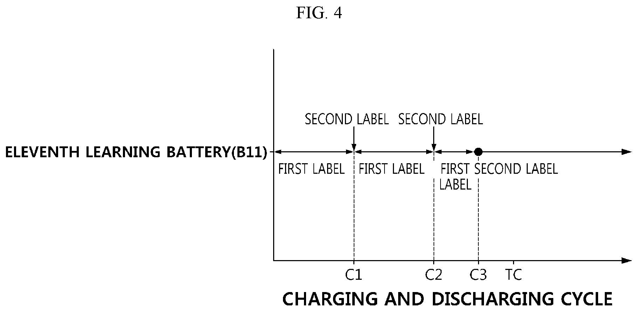

FIG. 4 is a diagram schematically showing the third embodiment in which a label is set by the battery management apparatus 100 according to an aspect of the present disclosure.

The labeling unit 130 may be configured to count the number of times that the state of the learning battery is judged as the defective state.

For example, in the embodiment of FIG. 4, the eleventh learning battery B11 may be judged as a defective state at the first charging and discharging cycle C1. The labeling unit 130 may set the number of times judged as a defective state for the eleventh learning battery B11 as 1 at the first charging and discharging cycle C1.

Also, the eleventh learning battery B11 may be judged as a defective state at the second charging and discharging cycle C2. The labeling unit 130 may set the number of times judged as a defective state for the eleventh learning battery B11 as 2 at the second charging and discharging cycle C2.

In addition, the eleventh learning battery B11 may be judged as a defective state at the third charging and discharging cycle C3. The labeling unit 130 may set the number of times judged as a defective state for the eleventh learning battery B11 as 3 at the third charging and discharging cycle C3.

When the counted number of times is equal to or greater than a criterion number of times, the labelling unit 130 may be configured to set the second label for the feature value of the learning battery for the charging and discharging cycle after the last charging and discharging cycle at which the state of the learning battery is judged as the defective state.

For example, in the embodiment of FIG. 4, it is assumed that the criterion number of times is preset as 3. Since the number of times judged as a defective state for the eleventh learning battery B11 at the third charging and discharging cycle C3 is set as 3, the labeling unit 130 may set the second label for the feature value after the third charging and discharging cycle C3.

In general, the state of the battery is degraded as the charging and discharging cycle progresses, but in some cases, the state of the battery may be temporarily restored. Also, in the process of judging the state of the battery, temporary noise may affect due to measurement errors caused by internal and external environmental problems. Therefore, the labeling unit 130 may set the second label even if the state of the learning battery is not judged, only when the state of the learning battery is judged as a defective state the criterion number of times or more.

Meanwhile, a predetermined condition may be further added to the criterion number of times. For example, if the state of the learning battery is continuously judged as a defective state and the number of times judged as a defective state is greater than or equal to the criterion number of times, the labeling unit 130 may be configured to set the second label for the feature value of the learning battery for a charging and discharging cycle after the last charging and discharging cycle at which the state of the learning battery is judged as a defective state.

The criterion number of times and the condition that may be added to the criterion number of times may be preset by a user in consideration of the type of battery, the usage of the battery, the environment in which the battery is used, or the like.

Meanwhile, the feature value extracting unit 110 may be configured to generate an additional feature value based on the extracted feature value at every charging and discharging cycle.

For example, it is assumed that a total of 10 learning batteries are provided, and the feature value extracting unit 110 has extracted feature values from the first charging and discharging cycle C1 to a cycle just before the 500^{th} charging and discharging cycle for each learning battery. In this case, a total of 5,000 feature values may be extracted.

The feature value extracting unit 110 may generate an additional feature value by combining feature values extracted at each charging and discharging cycle in order to further secure learning data for learning the classification model.

For example, the feature value extracting unit 110 may generate a plurality of groups for the plurality of feature values extracted at the same charging and discharging cycle, and calculate an average feature value for each generated group.

In addition, the feature value extracting unit 110 may be configured to generate a group for the same type of feature values.

For example, it is assumed that voltage and internal resistance are extracted as the feature values by the feature value extracting unit 110. In this case, a group for voltage may be generated based on the feature value for voltage, and a group for internal resistance may be generated based on the feature value for internal resistance. That is, a group for a mixture of voltage and internal resistance may not be generated.

In the preceding embodiment, the feature value extracting unit 110 may generate a group for 2 to 10 feature values among 10 feature values to be extracted at the same charging and discharging cycle, and may further generate an average feature value for each group. Here, the number of groups that can be generated from 10 feature values may be a total of 1,013.

Specifically, when the feature value extracting unit 110 generates a group by combining 2, 3, 4, 5, 6, 7, 8, 9, and 10 feature values among 10 feature values, the number of generated groups may be 45, 120, 210, 252, 210, 120, 45, 10, and 1, respectively. Accordingly, the total number of generated groups may be 1,013. The feature value extracting unit 110 may generate 1,013 additional feature values at every charging and discharging cycle by calculating an average feature value for each of the generated 1,013 groups.

The first state judging unit 120 may judge the state for a virtual learning battery based on each of the additional feature values generated by the feature value extracting unit 110. In addition, the labeling unit 130 may set a label for each additional feature value based on the judged state of the virtual learning battery. The model learning unit 140 may learn the classification model by using both the feature value for the learning battery and the feature value for the virtual learning battery.

That is, the battery management apparatus 100 has an advantage of securing a larger number of learning data based on the limited number of learning batteries by generating additional feature values for the virtual learning battery.

Meanwhile, the feature value extracting unit 110 may be configured to further consider the state of the learning battery judged by the first state judging unit 120 in the process of generating a group. That is, the feature value extracting unit 110 may be configured to generate a group by combining learning batteries having the same state judged by the first state judging unit 120.

For example, at the N^{th} charging and discharging cycle, it is assumed that the states of 6 learning batteries among 10 learning batteries are judged as a normal state, and the states of 4 learning batteries are judged as a defective state. The feature value extracting unit 110 may generate a plurality of groups by combining the feature values of 6 learning batteries judged as a normal state. In this case, a total of 57 groups may be generated. In addition, the feature value extracting unit 110 may generate a plurality of groups by combining the feature values of 4 learning batteries judged as a defective state. In this case, a total of 11 groups may be generated. In addition, the feature value extracting unit 110 may generate a total of 68 additional feature values by calculating an average feature value for each generated group.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the feature value extracting unit 110, the first state judging unit 120, the labelling unit 130, the model learning unit 140 and the second state judging unit 150 may be implemented as components of the BMS.

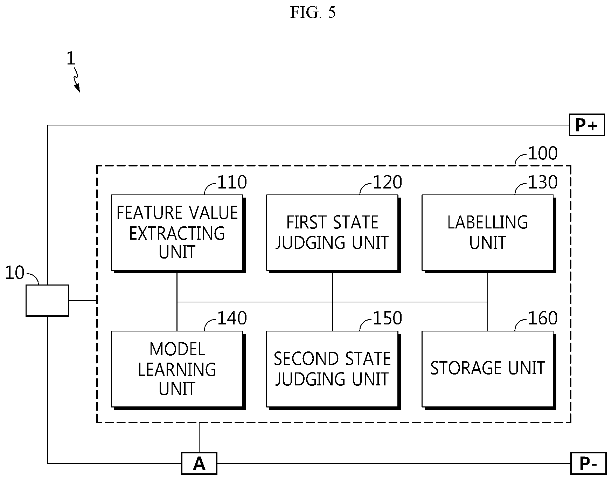

FIG. 5 is a diagram schematically showing an exemplary configuration of a battery pack 1 according to another aspect of the present disclosure.

Referring to FIG. 5, the battery management apparatus 100 according to the present disclosure may be provided in a battery pack 1. That is, the battery pack 1 according to the present disclosure may include the above-described battery management apparatus 100 and one or more battery modules 10. Here, the battery module 10 may include one or more battery cells connected in series and/or in parallel. In addition, the battery pack 1 may further include electrical equipment (relays, fuses, etc.) and a case.

For example, in the embodiment of FIG. 5, the feature value extracting unit 110 may be connected to the battery module 10 and a current measurement unit. The feature value extracting unit 110 may measure voltage, current, temperature, or the like of each battery cell included in the battery module 10 and extract it as a feature value. Also, the feature value extracting unit 110 may extract internal resistance, SOC, SOH, or the like of each battery cell as a feature value based on the measured values.

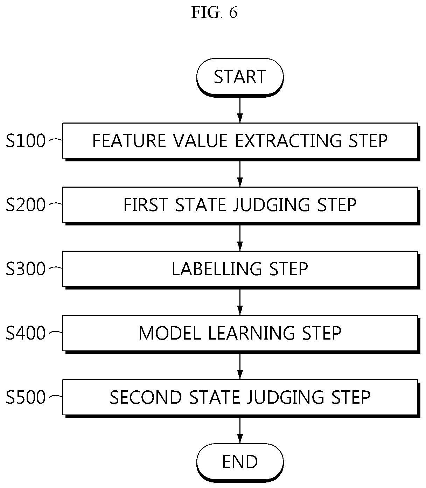

FIG. 6 is a diagram schematically showing a battery management method according to still another aspect of the present disclosure.

Preferably, each step of the battery management method may be performed by the battery management apparatus 100. Hereinafter, contents overlapping with the previously described contents will be omitted or briefly described.

The feature value extracting step (S100) is a step of extracting a feature value of a learning battery at every charging and discharging cycle, and may be performed by the feature value extracting unit 110.

The first state judging step (S200) is a step of judging the state of the learning battery at every charging and discharging cycle, based on the feature value extracted in the feature value extracting step (S100) and a criterion value preset to correspond to the feature value, and may be performed by the first state judging unit 120.

For example, it is assumed that first to N^{th} feature values for the learning battery are extracted at each of the first to N^{th} charging and discharging cycles. Here, N may be an integer of 2 or more. In this case, a total of N criterion values may be preset. That is, first to N^{th} criterion value may be preset to correspond to the first to N^{th} feature values, respectively. In addition, the first state judging unit 120 may judge the state of the learning battery at the first charging and discharging cycle by comparing the first feature value and the first criterion value. Similarly, the first state judging unit 120 may judge the state of the learning battery at the N^{th} charging and discharging cycle by comparing the N^{th} feature value and the N^{th} criterion value.

The labeling step (S300) is a step of setting a label for the feature value of the learning battery at every charging and discharging cycle, based on the state of the learning battery judged at the first state judging step (S200), and may be performed by the labeling unit 130.

Specifically, when the state of the learning battery is judged as a normal state, the labeling unit 130 may be configured to set a first label for the feature value of the learning battery for the corresponding charging and discharging cycle.

Conversely, when the state of the learning battery is judged as a defective state, the labeling unit 130 may be configured to set a second label for the feature value of the learning battery for the corresponding charging and discharging cycle.

The model learning step (S400) is a step of learning a classification model for judging the state of an analysis battery based on the feature value for which the label is set in the labeling step (S300), and may be performed by the model learning unit 140.

The second state judging step (S500) is a step of judging the state of the analysis battery based on the classification model learned in the model learning step (S400), and may be performed by the second state judging unit 150.

That is, the battery management method according to an embodiment of the present disclosure has an advantage of securing a large amount of learning data for learning the classification model from a limited number of batteries. Therefore, the performance of the learned classification model may be improved. Therefore, the accuracy of the state judgment of the analysis battery based on the classification model learned according to one embodiment of the present disclosure may be improved.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only. In this respect, the scope of the invention is defined by the appended claims.

### (Reference Signs)

1: battery pack
10: battery module
100: battery management apparatus
110: feature value extracting unit
120: first state judging unit
130: labelling unit
140: model learning unit
150: second state judging unit
160: storage unit

## Claims

1. A battery management apparatus (100), comprising:
a feature value extracting unit (110) configured to extract at least one feature value of a learning battery at every charging and discharging cycle, wherein the learning battery is a battery for obtaining a learning data set for learning a classification model, and is different from an analysis battery and wherein the at least one feature value is extracted according to one of a voltage, a current, a capacity, charging time, an internal resistance, a State of Charge, SOC, and a State of Health, SOH or a combination thereof;
a first state judging unit (120) configured to judge a state of the learning battery as a normal state or a defective state at every charging and discharging cycle, based on the at least one feature value extracted by the feature value extracting unit (110) and a preset criterion value that corresponds to the feature value, wherein the preset criterion value is a threshold value that is preset for each feature value for each charging and discharging cycle;
a labelling unit (130) configured to set a label for each extracted feature value of the learning battery at every charging and discharging cycle, based on whether the state of the learning battery judged by the first state judging unit (120) is the normal state or the defective state;
a model learning unit (140) configured to learn a classification model for judging a state of an analysis battery based on the at least one feature value for which the label is set by the labelling unit (130); and
a second state judging unit (150) configured to judge the state of the analysis battery based on the classification model learned by the model learning unit (140).

2. The battery management apparatus (100) according to claim 1,
wherein when the state of the learning battery is judged as the normal state, the labelling unit (130) is configured to set a first label to indicate the normal state of the learning battery for the corresponding charging and discharging cycle, and
wherein when the state of the learning battery is judged as the defective state, the labelling unit (130) is configured to set a second label to indicate the defective state of the learning battery for the corresponding charging and discharging cycle.

3. The battery management apparatus (100) according to claim 2,
wherein the labelling unit (130) is configured to set a label indicates the state of the learning battery, based on the state of the learning battery judged at a predetermined charging and discharging cycle.

4. The battery management apparatus (100) according to claim 3,
wherein when the state of the learning battery is judged as the normal state at the predetermined charging and discharging cycle, the labelling unit (130) is configured to set the first label to indicate the normal state of the learning battery for a charging and discharging cycle up to a cycle just before the predetermined charging and discharging cycle, and
wherein when the state of the learning battery is judged as the defective state at the predetermined charging and discharging cycle, the labelling unit (130) is configured to set the second label to indicate the defective state of the learning battery for each charging and discharging cycle after the predetermined charging and discharging cycle.

5. The battery management apparatus (100) according to claim 2,
wherein when the state of the learning battery is judged as the defective state, the labelling unit (130) is configured to set the second label to indicate the defective state learning battery for each subsequent charging and discharging cycle.

6. The battery management apparatus (100) according to claim 2,
wherein the labelling unit (130) is configured to count the number of times that the state of the learning battery is judged as the defective state, and when the counted number of times is equal to or greater than a criterion number of times, the labelling unit (130) is configured to set the second label to indicate the defective state of the learning battery for each charging and discharging cycle after a last charging and discharging cycle at which the state of the learning battery is judged as the defective state.

7. The battery management apparatus (100) according to claim 1,
wherein the feature value extracting unit (110) is configured to extract a plurality of feature values for the learning battery, and
wherein the first state judging unit (120) is configured to judge the state of the learning battery for each of the plurality of feature values at every charging and discharging cycle, based on the plurality of feature values of the learning battery and a criterion value corresponding to each of the plurality of feature values, wherein the preset criterion values are threshold values that are preset for each respective feature value for each charging and discharging cycle.

8. The battery management apparatus (100) according to claim 7,
wherein the labelling unit (130) is configured to set the label for each of the plurality of feature values at every charging and discharging cycle.

9. The battery management apparatus (100) according to claim 1,
wherein the second state judging unit (150) is configured to extract a feature value of the analysis battery at every charging and discharging cycle and judge the state of the analysis battery by inputting the extracted feature value to the learned classification model.

10. A battery pack (10), comprising the battery management apparatus (100) according to any one of claims 1 to 9.

11. A battery management method performed by a battery management apparatus (100), the method comprising:
a feature value extracting step (S100) of extracting at least one feature value of a learning battery at every charging and discharging cycle, wherein the learning battery is a battery for obtaining a learning data set for learning a classification model, and is different from an analysis battery and wherein the at least one feature value is extracted according to one of a voltage, a current, a capacity, charging time, an internal resistance, a State of Charge, SOC, and a State of Health, SOH or a combination thereof;
a first state judging step (S200) of judging a state of the learning battery at every charging and discharging cycle, based on the at least one feature value extracted in the feature value extracting step (S100) and a preset criterion value that corresponds to the feature value, wherein the preset criterion value is a threshold value that is preset for each feature value for each charging and discharging cycle;
a labelling step (S300) of setting a label for the each extracted feature value of the learning battery at every charging and discharging cycle, based on the state of the learning battery judged in the first state judging step (S200), wherein the label indicates the state of the learning battery to be in a normal state or a defective state;
a model learning step (S400) of learning a classification model for judging a state of an analysis battery based on the at least one feature value for which the label is set in the labelling step (S300); and
a second state judging step (S500) of judging the state of the analysis battery based on the classification model learned in the model learning step (S400).

## Patentansprüche

1. Batterieverwaltungsvorrichtung (100), umfassend:
eine Merkmalswertextraktionseinheit (110), die konfiguriert ist, um mindestens einen Merkmalswert einer Lernbatterie bei jedem Lade- und Entladezyklus zu extrahieren, wobei die Lernbatterie eine Batterie zum Erhalten eines Lerndatensatzes zum Lernen eines Klassifizierungsmodells ist und sich von einer Analysebatterie unterscheidet und wobei der mindestens eine Merkmalswert gemäß einem von einer Spannung, einem Strom, einer Kapazität, einer Ladezeit, einem Innenwiderstand, einem Ladezustand, SOC, und einem Gesundheitszustand, SOH, oder einer Kombination davon extrahiert wird;
eine erste Zustandsbeurteilungseinheit (120), die konfiguriert ist, um einen Zustand der Lernbatterie als einen normalen Zustand oder einen fehlerhaften Zustand bei jedem Lade- und Entladezyklus zu beurteilen, basierend auf dem mindestens einen Merkmalswert, der durch die Merkmalswertextraktionseinheit (110) extrahiert wird, und einem voreingestellten Kriteriumswert, der dem Merkmalswert entspricht, wobei der voreingestellte Kriteriumswert ein Schwellenwert ist, der für jeden Merkmalswert für jeden Lade- und Entladezyklus voreingestellt ist;
eine Kennzeichnungseinheit (130), die konfiguriert ist, um basierend darauf, ob der Zustand der Lernbatterie, der durch die erste Zustandsbeurteilungseinheit (120) beurteilt wird, der normale Zustand oder der fehlerhafte Zustand ist, eine Kennzeichnung für jeden extrahierten Merkmalswert der Lernbatterie bei jedem Lade- und Entladezyklus zu vergeben;
eine Modelllerneinheit (140), die konfiguriert ist, um ein Klassifizierungsmodell zum Beurteilen eines Zustands einer Analysebatterie basierend auf dem mindestens einen Merkmalswert, für den die Kennzeichnung durch die Kennzeichnungseinheit (130) vergeben wird, zu lernen; und
eine zweite Zustandsbeurteilungseinheit (150), die konfiguriert ist, um den Zustand der Analysebatterie basierend auf dem Klassifizierungsmodell, das durch die Modelllerneinheit (140) gelernt wird, zu beurteilen.

2. Batterieverwaltungsvorrichtung (100) nach Anspruch 1,
wobei, wenn der Zustand der Lernbatterie als der normale Zustand beurteilt wird, die Kennzeichnungseinheit (130) konfiguriert ist, um eine erste Kennzeichnung zu vergeben, um den normalen Zustand der Lernbatterie für den entsprechenden Lade- und Entladezyklus anzuzeigen, und
wobei, wenn der Zustand der Lernbatterie als der fehlerhafte Zustand beurteilt wird, die Kennzeichnungseinheit (130) konfiguriert ist, um eine zweite Kennzeichnung zu vergeben, um den fehlerhaften Zustand der Lernbatterie für den entsprechenden Lade- und Entladezyklus anzuzeigen.

3. Batterieverwaltungsvorrichtung (100) nach Anspruch 2,
wobei die Kennzeichnungseinheit (130) konfiguriert ist, um basierend auf dem Zustand der Lernbatterie, der bei einem vorbestimmten Lade- und Entladezyklus beurteilt wird, eine Kennzeichnung zu vergeben, die den Zustand der Lernbatterie anzeigt.

4. Batterieverwaltungsvorrichtung (100) nach Anspruch 3,
wobei, wenn der Zustand der Lernbatterie bei dem vorbestimmten Lade- und Entladezyklus als der normale Zustand beurteilt wird, die Kennzeichnungseinheit (130) konfiguriert ist, um die erste Kennzeichnung zu vergeben, um den normalen Zustand der Lernbatterie für einen Lade- und Entladezyklus bis zu einem Zyklus unmittelbar vor dem vorbestimmten Lade- und Entladezyklus anzuzeigen, und
wobei, wenn der Zustand der Lernbatterie bei dem vorbestimmten Lade- und Entladezyklus als der fehlerhafte Zustand beurteilt wird, die Kennzeichnungseinheit (130) konfiguriert ist, um die zweite Kennzeichnung zu vergeben, um den fehlerhaften Zustand der Lernbatterie für jeden Lade- und Entladezyklus nach dem vorbestimmten Lade- und Entladezyklus anzuzeigen.

5. Batterieverwaltungsvorrichtung (100) nach Anspruch 2,
wobei, wenn der Zustand der Lernbatterie als der fehlerhafte Zustand beurteilt wird, die Kennzeichnungseinheit (130) konfiguriert ist, um die zweite Kennzeichnung zu vergeben, um die Lernbatterie mit fehlerhaftem Zustand für jeden nachfolgenden Lade- und Entladezyklus anzuzeigen.

6. Batterieverwaltungsvorrichtung (100) nach Anspruch 2,
wobei die Kennzeichnungseinheit (130) konfiguriert ist, um die Anzahl von Malen zu zählen, die der Zustand der Lernbatterie als der fehlerhafte Zustand beurteilt wird, und wenn die gezählte Anzahl von Malen gleich oder größer als eine Kriteriumsanzahl von Malen ist, die Kennzeichnungseinheit (130) konfiguriert ist, um die zweite Kennzeichnung zu vergeben, um den fehlerhaften Zustand der Lernbatterie für jeden Lade- und Entladezyklus nach einem letzten Lade- und Entladezyklus anzuzeigen, bei dem der Zustand der Lernbatterie als der fehlerhafte Zustand beurteilt wird.

7. Batterieverwaltungsvorrichtung (100) nach Anspruch 1,
wobei die Merkmalswertextraktionseinheit (110) konfiguriert ist, um eine Vielzahl von Merkmalswerten für die Lernbatterie zu extrahieren, und
wobei die erste Zustandsbeurteilungseinheit (120) konfiguriert ist, um den Zustand der Lernbatterie für jeden der Vielzahl von Merkmalswerten bei jedem Lade- und Entladezyklus zu beurteilen, basierend auf der Vielzahl von Merkmalswerten der Lernbatterie und einem Kriteriumswert, der jedem der Vielzahl von Merkmalswerten entspricht, wobei die voreingestellten Kriteriumswerte Schwellenwerte sind, die für jeden jeweiligen Merkmalswert für jeden Lade- und Entladezyklus voreingestellt sind.

8. Batterieverwaltungsvorrichtung (100) nach Anspruch 7,
wobei die Kennzeichnungseinheit (130) konfiguriert ist, um die Kennzeichnung für jeden der Vielzahl von Merkmalswerten bei jedem Lade- und Entladezyklus zu vergeben.

9. Batterieverwaltungsvorrichtung (100) nach Anspruch 1,
wobei die zweite Zustandsbeurteilungseinheit (150) konfiguriert ist, um einen Merkmalswert der Analysebatterie bei jedem Lade- und Entladezyklus zu extrahieren und den Zustand der Analysebatterie durch Eingeben des extrahierten Merkmalswerts in das gelernte Klassifizierungsmodell zu beurteilen.

10. Batteriepack (10), umfassend die Batterieverwaltungsvorrichtung (100) nach einem der Ansprüche 1 bis 9.

11. Batterieverwaltungsverfahren, das von einer Batterieverwaltungsvorrichtung (100) durchgeführt wird, wobei das Verfahren umfasst:
einen Merkmalswertextraktionsschritt (S100) zum Extrahieren mindestens eines Merkmalswerts einer Lernbatterie bei jedem Lade- und Entladezyklus, wobei die Lernbatterie eine Batterie zum Erhalten eines Lerndatensatzes zum Lernen eines Klassifizierungsmodells ist und sich von einer Analysebatterie unterscheidet und wobei der mindestens eine Merkmalswert gemäß einem von einer Spannung, einem Strom, einer Kapazität, einer Ladezeit, einem Innenwiderstand, einem Ladezustand, SOC, und einem Gesundheitszustand, SOH, oder einer Kombination davon extrahiert wird;
einen ersten Zustandsbeurteilungsschritt (S200) zum Beurteilen eines Zustands der Lernbatterie bei jedem Lade- und Entladezyklus, basierend auf dem mindestens einen Merkmalswert, der in dem Merkmalswertextraktionsschritt (S100) extrahiert wird, und einem voreingestellten Kriteriumswert, der dem Merkmalswert entspricht, wobei der voreingestellte Kriteriumswert ein Schwellenwert ist, der für jeden Merkmalswert für jeden Lade- und Entladezyklus voreingestellt ist;
einen Kennzeichnungsschritt (S300) zum Vergeben einer Kennzeichnung für jeden extrahierten Merkmalswert der Lernbatterie bei jedem Lade- und Entladezyklus, basierend auf dem Zustand der Lernbatterie, der in dem ersten Zustandsbeurteilungsschritt (S200) beurteilt wird, wobei die Kennzeichnung anzeigt, dass der Zustand der Lernbatterie in einem normalen Zustand oder einem fehlerhaften Zustand ist;
einen Modelllernschritt (S400) zum Lernen eines Klassifizierungsmodells zum Beurteilen eines Zustands einer Analysebatterie basierend auf dem mindestens einen Merkmalswert, für den die Kennzeichnung in dem Kennzeichnungsschritt (S300) vergeben wird; und
einen zweiten Zustandsbeurteilungsschritt (S500) zum Beurteilen des Zustands der Analysebatterie basierend auf dem Klassifizierungsmodell, das in dem Modelllernschritt (S400) gelernt wird.

## Revendications

1. Appareil de gestion de batterie (100), comprenant :
une unité d'extraction de valeur de caractéristique (110) configurée pour extraire une ou plusieurs valeurs de caractéristique d'une batterie d'apprentissage à chaque cycle de charge et de décharge, dans lequel la batterie d'apprentissage est une batterie permettant d'obtenir un ensemble de données d'apprentissage pour apprendre un modèle de classification, et est différent d'une batterie d'analyse et dans lequel la ou les valeurs de caractéristique sont extraites selon une valeur parmi une tension, un courant, une capacité, une durée de charge, une résistance interne, un état de charge (State de Charge ou SOC) et un état de santé (State de Health ou SOH) ou une combinaison de ces derniers ;
une première unité de détermination d'état (120) configurée pour déterminer qu'un état de la batterie d'apprentissage est un état normal ou un état défectueux à chaque cycle de charge et de décharge, sur la base de la ou des valeurs de caractéristique extraites par l'unité d'extraction de valeur de caractéristique (110) et une valeur de critère prédéfinie qui correspond à la valeur de caractéristique, dans lequel la valeur de critère prédéfinie est une valeur de seuil qui est prédéfinie pour chaque valeur de caractéristique pour chaque cycle de charge et de décharge ;
une unité de marquage (130) configurée pour définir un marqueur pour chaque valeur de caractéristique extraite de la batterie d'apprentissage à chaque cycle de charge et de décharge, sur la base de si l'état de la batterie d'apprentissage déterminé par la première unité de détermination d'état (120) est l'état normal ou l'état défectueux ;
une unité d'apprentissage de modèle (140) configurée pour apprendre un modèle de classification pour déterminer un état d'une batterie d'analyse sur la base de la ou des valeurs de caractéristique pour lesquelles le marqueur est défini par l'unité de marquage (130) ; et
une deuxième unité de détermination d'état (150) configurée pour déterminer l'état de la batterie d'analyse sur la base du modèle de classification appris par l'unité d'apprentissage de modèle (140).

2. Appareil de gestion de batterie (100) selon la revendication 1,
dans lequel, quand l'état de la batterie d'apprentissage est déterminé être l'état normal, l'unité de marquage (130) est configurée pour définir un premier marqueur pour indiquer l'état normal de la batterie d'apprentissage pour le cycle de charge et de décharge correspondant, et
dans lequel, quand l'état de la batterie d'apprentissage est déterminé être l'état défectueux, l'unité de marquage (130) est configurée pour définir un deuxième marqueur pour indiquer l'état défectueux de la batterie d'apprentissage pour le cycle de charge et de décharge correspondant.

3. Appareil de gestion de batterie (100) selon la revendication 2,
dans lequel l'unité de marquage (130) est configurée pour définir un marqueur qui indique l'état de la batterie d'apprentissage, sur la base de l'état de la batterie d'apprentissage déterminé à un cycle de charge et de décharge prédéterminé.

4. Appareil de gestion de batterie (100) selon la revendication 3,
dans lequel, quand l'état de la batterie d'apprentissage est déterminé être l'état normal au cycle de charge et de décharge prédéterminé, l'unité de marquage (130) est configurée pour définir le premier marqueur pour indiquer l'état normal de la batterie d'apprentissage pour un cycle de charge et de décharge jusqu'à un cycle juste avant le cycle de charge et de décharge prédéterminé, et
dans lequel, quand l'état de la batterie d'apprentissage est déterminé être l'état défectueux au cycle de charge et de décharge prédéterminé, l'unité de marquage (130) est configurée pour définir le deuxième marqueur pour indiquer l'état défectueux de la batterie d'apprentissage pour chaque cycle de charge et de décharge après le cycle de charge et de décharge prédéterminé.

5. Appareil de gestion de batterie (100) selon la revendication 2,
dans lequel, quand l'état de la batterie d'apprentissage est déterminé être l'état défectueux, l'unité de marquage (130) est configurée pour définir le deuxième marqueur pour indiquer la batterie d'apprentissage en état défectueux pour chaque cycle de charge et de décharge subséquent.

6. Appareil de gestion de batterie (100) selon la revendication 2,
dans lequel l'unité de marquage (130) est configurée pour compter le nombre de fois où l'état de la batterie d'apprentissage est déterminé être l'état défectueux, et quand le nombre de fois compté est égal ou supérieur à un nombre de fois critère, l'unité de marquage (130) est configurée pour définir le deuxième marqueur pour indiquer l'état défectueux de la batterie d'apprentissage pour chaque cycle de charge et de décharge après un dernier cycle de charge et de décharge où l'état de la batterie d'apprentissage est déterminé être l'état défectueux.

7. Appareil de gestion de batterie (100) selon la revendication 1,
dans lequel l'unité d'extraction de valeur de caractéristique (110) est configurée pour extraire une pluralité de valeurs de caractéristique pour la batterie d'apprentissage, et
dans lequel la première unité de détermination d'état (120) est configurée pour déterminer l'état de la batterie d'apprentissage pour chaque valeur de caractéristique de la pluralité de valeurs de caractéristique à chaque cycle de charge et de décharge, sur la base de la pluralité de valeurs de caractéristique de la batterie d'apprentissage et d'une valeur de critère correspondant à chaque valeur de caractéristique de la pluralité de valeurs de caractéristique, dans lequel les valeurs de critère prédéfinies sont des valeurs de seuil qui sont prédéfinies pour chaque valeur de caractéristique respective pour chaque cycle de charge et de décharge.

8. Appareil de gestion de batterie (100) selon la revendication 7,
dans lequel l'unité de marquage (130) est configurée pour définir le marqueur pour chaque valeur de caractéristique de la pluralité de valeurs de caractéristique à chaque cycle de charge et de décharge.

9. Appareil de gestion de batterie (100) selon la revendication 1,
dans lequel la deuxième unité de détermination d'état (150) est configurée pour extraire une valeur de caractéristique de la batterie d'analyse à chaque cycle de charge et de décharge et déterminer l'état de la batterie d'analyse en entrant la valeur de caractéristique extraite dans le modèle de classification appris.

10. Bloc-batterie (10), comprenant l'appareil de gestion de batterie (100) selon l'une quelconque des revendications 1 à 9.

11. Procédé de gestion de batterie effectué par un appareil de gestion de batterie (100), le procédé comprenant :
une étape d'extraction de valeur de caractéristique (S100) consistant à extraire une ou plusieurs valeurs de caractéristique d'une batterie d'apprentissage à chaque cycle de charge et de décharge, dans lequel la batterie d'apprentissage est une batterie permettant d'obtenir un ensemble de données d'apprentissage pour apprendre un modèle de classification, et est différente d'une batterie d'analyse et dans lequel la ou les valeurs de caractéristique sont extraites selon une valeur de caractéristique parmi une tension, un courant, une capacité, une durée de charge, une résistance interne, un état de charge (State de Charge ou SOC) et un état de santé (State de Health ou SOH) ou une combinaison de ces derniers ;
une première étape de détermination d'état (S200) consistant à déterminer un état de la batterie d'apprentissage à chaque cycle de charge et de décharge, sur la base de la ou des valeurs de caractéristique extraites à l'étape d'extraction de valeur de caractéristique (S100) et d'une valeur de critère prédéfinie qui correspond à la valeur de caractéristique, dans lequel la valeur de critère prédéfinie est une valeur de seuil qui est prédéfinie pour chaque valeur de caractéristique pour chaque cycle de charge et de décharge ;
une étape de marquage (S300) consistant à définir un marqueur pour chaque valeur de caractéristique extraite de la batterie d'apprentissage à chaque cycle de charge et de décharge, sur la base de l'état de la batterie d'apprentissage déterminé à la première étape de détermination d'état (S200), dans lequel le marqueur indique que l'état de la batterie d'apprentissage est dans un état normal ou un état défectueux ;
une étape d'apprentissage de modèle (S400) consistant à apprendre un modèle de classification pour déterminer un état d'une batterie d'analyse sur la base de la ou des valeurs de caractéristique pour lesquelles le marqueur est défini à l'étape de marquage (S300) ; et
une deuxième étape de détermination d'état (S500) consistant à déterminer l'état de la batterie d'analyse sur la base du modèle de classification appris à l'étape d'apprentissage de modèle (S400).
